Europäisches Patentamt

European Patent Office

Office européen des brevets

(19)

(11) Numéro de publication: **0 229 553**
**A1**

# (12) DEMANDE DE BREVET EUROPEEN

(21) Numéro de dépôt: **86402684.4**

(22) Date de dépôt: **03.12.86**

(51) Int. Cl.4: **G01L 1/22**

(30) Priorité: **04.12.85 FR 8517943**
**17.02.86 FR 8602111**

(43) Date de publication de la demande:
**22.07.87 Bulletin 87/30**

(84) Etats contractants désignés:
**DE FR GB IT NL SE**

(71) Demandeur: **SEB S.A.**

**F-21260 Selongey(FR)**

(72) Inventeur: **Sarrazin, Michel**
**Marigny Massingy**
**F-74150 Rumilly(FR)**
Inventeur: **Depret, Claudy**
**Les Balmes Sâles**
**F-74150 Rumilly(FR)**

(74) Mandataire: **Bouju, André**
**Cabinet Bouju 38 avenue de la Grande Armée**
**F-75017 Paris(FR)**

(54) **Procédé pour fabriquer et appliquer des jauges de contrainte, et jauges de contrainte obtenues notamment au cours de ce procédé.**

(57) Une jauge de contrainte comprend un circuit électrique (7) tenu, préalablement à son montage, par un film-support (1).

On colle l'ensemble sur un corps d'épreuve (6), dont les déformations sont à capter, le circuit (7) étant directement appliqué contre une face (6a) du corps (6) rendue isolante par oxydation. On pèle ensuite le film-support (1) pour ne laisser subsister sur le corps (6) que le circuit (7). La colle utilisée entre le circuit (7) et le film (1) est prévue pour cela.

Utilisation pour éviter que le film-support ait è transmettre les déformations entre le corps d'épreuve et le circuit électrique de la jauge de contrainte.

FIG. 14

## "Procédé pour fabriquer et appliquer des jauges de contrainte, et jauges de contrainte obtenues notamment au cours de ce procédé"

La présente invention concerne un procédé pour réaliser des jauges de contrainte et les appliquer sur un corps d'épreuve.

La présente invention concerne également, à titre notamment de produits intermédiaires obtenus par ce procédé, des jauges de contrainte munies d'un circuit électrique à au moins une résistance sensible.

On connaît les jauges comprenant un circuit à résistance sensible collé sur un film-support dont la face ne portant pas le circuit est destinée à être à son tour collée sur le corps d'épreuve. Ainsi, le film-support est interposé entre le corps d'épreuve et le circuit.

Le film support facilite la manipulation. Cependant, l'avantage ainsi obtenu est limité car le film-support doit être très mince, donc fragile, pour bien transmettre au circuit électrique les déformations du corps d'épreuve.

En pratique, les épaisseurs des films-support habituellement utilisés sont si faibles que la fabrication des jauges par un processus automatique est rendue difficile. Malgré cela, la transmission des déformations n'est pas excellente, et en particulier le collage du film-support sur le corps d'épreuve est délicat : la transmission des déformations sera mauvaise si une bulle d'air reste prisonnière entre corps d'épreuve et film-support.

Pour faciliter la fabrication des jauges de contrainte, on pourrait songer à s'inspirer d'un procédé connu pour fabriquer des circuits électriques miniaturisés, dans lequel on grave ces circuits sur une bande métallique continue de faible épaisseur, préalablement collée sur un film-support en forme de bande en matière plastique.

Selon ce procédé connu, le film-support en matière plastique est muni d'ouvertures, découpées régulièrement le long du film avant collage de la bande métallique.

On grave ensuite la bande métallique de façon à obtenir un circuit électrique. Cette gravure est réalisée par la méthode classique de photogravure (enduction d'une matière photosensible, insolation au travers d'un masque, développement puis attaque chimique).

La gravure réalisée dans la bande métallique a pour effet de former des pattes métalliques s'étendant librement en regard des ouvertures ménagées dans la bande de support, afin de pouvoir être raccordées à d'autres circuits électriques.

Le film-support continu en matière plastique permet ainsi de réaliser en continu des circuits électriques en constituant un support mécanique et isolant pour ceux-ci, qui facilite considérablement la manipulation de ces circuits.

Malheureusement, ce procédé n'est pas directement transposable à la fabrication des jauges de contrainte de type connu car il nécessite de la part du film-support une résistance mécanique incompatible avec la bonne transmission des déformations.

Le but de l'invention est ainsi de proposer un procédé du genre indiqué au début et qui facilite considérablement la fabrication des jauges de contrainte, leur manipulation postérieurement à la fabrication, leur bonne application sur le corps d'épreuve, et qui assure que la transmission des déformations entre le corps d'épreuve et la jauge soit améliorée en service.

Suivant un premier aspect du procédé selon l'invention, pour fabriquer une jauge de contrainte et l'appliquer sur un corps d'épreuve :

-on colle une couche métallique sur l'une des faces d'un film-support ;

-on grave la couche métallique selon les contours d'un circuit électrique comprenant au moins une résistance sensible ;

-on amène l'ensemble film-support -circuit sur une surface isolante du corps d'épreuve de façon que le circuit soit interposé entre le film-support et le corps d'épreuve ; et

-on colle le circuit électrique sur la surface isolante du corps d'épreuve.

Ainsi, le film-support utile pour la manutention jusqu'au moment du collage n'a pas de fonction d'isolation électrique entre le circuit et le corps d'épreuve. Cette fonction d'isolation est assurée par une surface isolante du corps d'épreuve. Cette surface isolante est directement disponible si le corps d'épreuve est en matière isolante. Dans le cas plus fréquent où le corps d'épreuve est conducteur, par exemple métallique, la surface isolante résulte d'un traitement préalable du corps d'épreuve, par exemple traitement de surface chimique ou dépôt d'une couche isolante. Un telle couche isolante ne réintroduit pas les inconvénients de mauvaise transmission des déformations car elle peut être appliquée à l'état liquide ou semi-liquide ce qui lui permet ensuite d'être en parfaite liaison mécanique avec le corps d'épreuve.

Suivant un deuxième aspect du procédé selon l'invention, pour fabriquer une jauge de contrainte et l'appliquer sur un corps d'épreuve :

-on grave, selon les contours d'un circuit électrique comprenant au moins une résistance sensible, une couche métallique portée par un film-support ; et
-après avoir polymérisé au contact de la couche métallique une couche de matière adhésive de façon que celle-ci ait, dans la région du circuit électrique, une face libre et une face adjacente au circuit, on colle sur le corps d'épreuve la face libre de la couche de matière adhésive polymérisée.

Cet aspect du procédé se distingue du précédent en ce que le moyen d'isolation électrique est aménagé sur la jauge de contrainte préalablement à sa pose, au lieu d'être fourni par ou aménagé sur le corps d'épreuve.

Cependant, comme le premier aspect, le second aspect est basé sur l'idée inventive consistant à utiliser le film-support comme moyen de manutention indépendant de toute isolation interposée entre le corps d'épreuve et le circuit électrique. La couche de matière adhésive polymérisée qui remplit cette fonction d'isolation peut être relativement mince et souple pour transmettre les déformations de manière optimale, car la résistance mécanique nécessaire avant la pose sur le corps d'épreuve est assurée par le film-support.

Un circuit électrique peut avoir un film-support individuel pour constituer une jauge de contrainte individuelle, ou être associé à un film-support ayant la forme d'une bande sur laquelle des circuits électriques semblables sont réalisés les uns à la suite des autres sur la bande.

Dans une jauge de contrainte prévue pour être collée sur le corps d'épreuve de façon que le circuit électrique soit interposé entre le corps d'épreuve et le film-support, le collage associant le circuit électrique au film-support est d'un type à faible adhérance permettant de détacher le film-support du circuit électrique par pelage.

Ainsi, dans une telle jauge de contrainte, le film-support ne sert qu'à la manutention depuis la fabrication jusqu'à la mise en place sur le corps d'épreuve, et disparaît ensuite.

Selon un autre mode de réalisation, la jauge de contrainte comprend une couche intermédiaire entre le film-support et le circuit électrique, ce dernier étant porté par la couche intermédiaire et s'inscrivant dans une ouverture du film-support lorsqu'il est vu perpendiculairement au film-support.

Pour poser une telle jauge, on place le corps d'épreuve contre le film-support, et on pousse le circuit électrique à travers l'ouverture du film-support pour l'appliquer contre le corps d'épreuve, la couche intermédiaire ou une substance additionnelle assurant le collage. Le film-support peut ensuite être éloigné du corps d'épreuve.

Selon un troisième mode de réalisation de la jauge de contrainte, le film-support présente une ouverture donnant accès, depuis le côté du film-support opposé au circuit, à des surfaces de connexion du circuit électrique, le circuit électrique étant collé au film-support en dehors de l'ouverture précitée.

Pour mettre en service cette jauge, on la colle sur le corps d'épreuve de façon que le circuit électrique soit interposé entre le corps d'épreuve et le film-support. Ensuite, on raccorde électriquement le circuit électrique avec un équipement d'exploitation à travers au moins une ouverture du film-support. On peut également effectuer à travers cette ouverture l'ajustage des valeurs électriques du circuit, par coupure, grattage ou soudure en des positions appropriées prévues sur le circuit.

Pour que le film-support résiste convenablement aux manipulations industrielles, son épaisseur peut être de l'ordre de 20 micromètres.

D'autres particularités et avantages de l'invention ressortiront encore de la description ci-après.

Aux dessins annexés, donnés à titre d'exemples non limitatifs :

-la figure 1 est une vue en plan avec arrachements du film-support en matière plastique utilisé dans le procédé selon l'invention ;

-la figure 2 est une vue à plus grande échelle de ce film ;

-la figure 3 est une vue en coupe longitudinale du film-support en matière plastique et de la bande métallique collée à celui-ci par l'intermédiaire d'une couche adhésive ;

-la figure 4 est une vue analogue à la figure 3, après gravure de la bande métallique et amenée d'un outil pour appliquer le circuit gravé sur un corps d'épreuve ;

-la figure 5 est une vue en plan du film-support, montrant le circuit électrique gravé dans la couche métallique ;

-la figure 6 est une vue schématique en coupe du circuit électrique déposé sur le corps d'épreuve ;

-la figure 7 est une vue analogue à la figure 1 d'un deuxième mode de réalisation du film-support en vue de la mise en oeuvre d'une variante du procédé ;

-la figure 8 est une vue du film-support en coupe longitudinale, sur lequel est collée la couche métallique ;

-la figure 9 est une vue en plan du circuit obtenu par gravure de la couche métallique sur le film-support ;

- la figure 10 est une vue analogue à la figure 8 mais après gravure de la couche métallique et application de celle-ci sur un corps d'épreuve ;

-la figure 11 est une vue analogue à la figure 8 mais montrant l'ensemble film-support -couche métallique utilisé dans le cadre d'une seconde variante du procédé ;

-la figure 12 est une vue analogue à la figure 11 mais après gravure de la couche métallique ;

-la figure 13 est une vue en plan du circuit obtenu par gravure de la couche métallique sur le film-support ;

-la figure 14 est une vue en coupe du corps d'épreuve et de la jauge de contrainte appliquée sur lui, lors du pelage du film-support ;

-la figure 15 est une vue en coupe longitudinale de la bande de support en matière plastique, de la bande métallique collée contre celle-ci et de la couche adhésive appliquée contre cette dernière, dans un quatrième mode de mise en oeuvre de l'invention ;

-la figure 16 est une vue analogue à la figure 15, après gravure de la bande métallique ;

-la figure 17 est une vue de dessus de la bande de support, montrant le circuit électrique gravé dans la bande métallique ;

-la figure 18 est une vue schématique en élévation, illustrant un procédé de mise en place en continu de jauges de contraintes sur des corps d'épreuve pour appareil de pesage ; et

- la figure 19 est une vue en élévation d'un corps d'épreuve muni de jauges de contraintes.

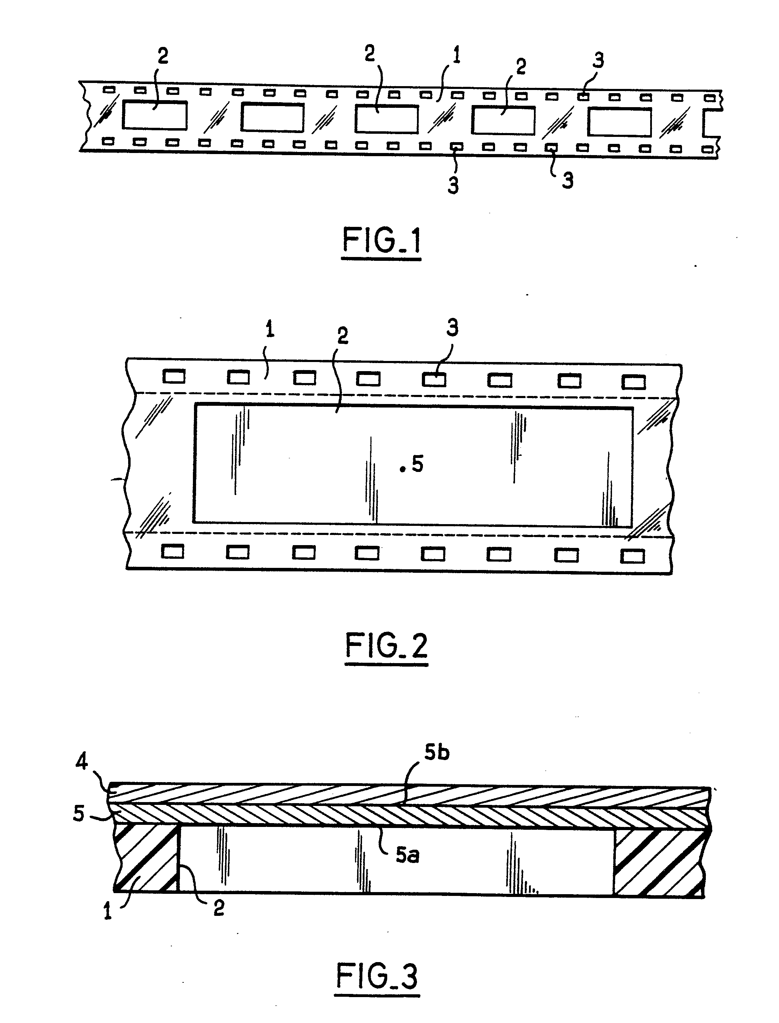

En référence aux figures 1 à 6, le procédé pour fabriquer une jauge de contrainte et l'appliquer sur un corps d'épreuve comprend les étapes suivantes :

-on réalise (voir figure 1) dans une bande de matière plastique constituant un film-support 1, des ouvertures 2 régulièrement espacées, en même temps que des ouvertures latérales 3 de plus faible dimension, destinées à l'entraînement de la bande 1 à la manière d'un film cinématographique ;

-on réalise d'autre part une bande composite comprenant une couche métallique 4 et une couche de matière adhésive réticulable 5 ;

-on applique le film-support 1 contre le côté de la couche de matière adhésive 5 qui est opposé à la couche métallique 4 (figures 2 et 3) de façon que la bande composite laisse libres les ouvertures 3 du film-support 1 et ferme complètement les ouvertures 2 de celui-ci. Ainsi, dans les ouvertures 2, la couche 5 a une face libre 5a adjacente au film 1 et une face 5b adjacente à la couche métallique 4 ;

-on grave selon le procédé connu de photogravure la couche métallique 4 depuis sa face opposée à la couche 5, et selon les contours d'un circuit électrique 7, de façon que le circuit 7 s'inscrive dans le contour d'une ouverture 2 du film 1 lorsque celui-ci est vu perpendiculairement à sa surface ;

-d'autre part, on dépose une couche de colle sur une surface du corps d'épreuve 6 ;

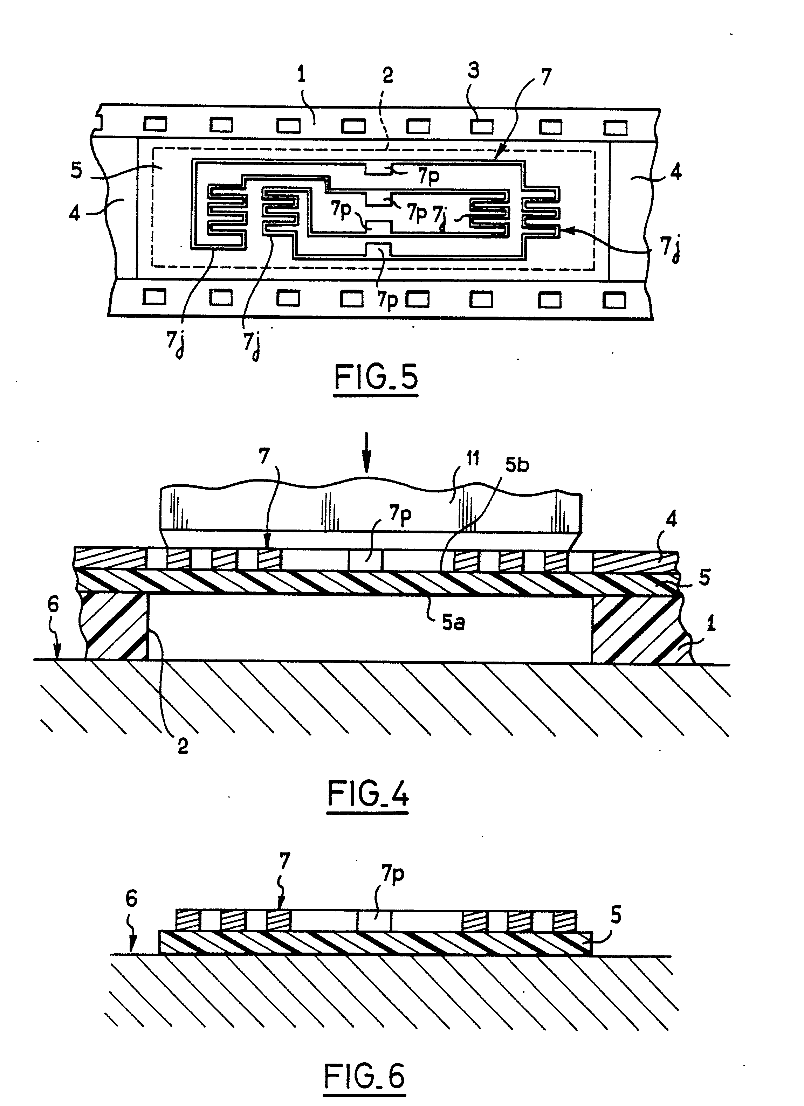

-on amène le film-support muni de la couche 5 et de la couche 4 gravée contre la couche de colle du corps d'épreuve 6, le film-support 1 étant adjacent au corps 6 (figure 4) ;

-on amène un outil 11 du genre poinçon sur le circuit 7 et on actionne le poinçon 11 vers le corps d'épreuve 6 pour pousser le circuit 7 et la région attenante de la couche 5 à travers l'ouverture 2 pour appliquer ladite région de la couche 5 contre la surface encollée du corps 6 (figure 6) ;

-on éloigne le film 1 et on retire le poinçon 11.

Les opérations qui viennent d'être décrites ci-dessus peuvent être réalisées en continu. Plus particulièrement, les couches 4 et 5 peuvent être assemblées en continu entre elles, puis avec le film-support 1, à la suite de quoi les circuits 7 sont gravés les uns après les autres, chacun au droit des ouvertures 2 du film 1. Le film 1, par exemple en polyimide, a une épaisseur comprise entre 20 et 100 microns, suffisante pour que le film-support et les éléments qu'il porte soient entraînés sans risque de rupture dans une machine automatique de fabrication.

On appelle jauge de contrainte l'ensemble comprenant le circuit 7, la région adjacente de la couche 5 et, éventuellement, la région adjacente du film 1, comprenant une ouverture 2.

Le rôle de la couche 5 est de maintenir le circuit 7 en regard de l'ouverture 2 lorsque le circuit est encore porté par le film 1, puis d'assurer la liaison mécanique entre le corps d'épreuve et le circuit après enlèvement du film.

Dans l'exemple représenté, le circuit 7 comprend différentes résistances sensibles 7j (figure 5) et des surfaces 7p pour raccorder le circuit 7 avec un équipement d'exploitation. Ce genre de jauge est utilisable sur le corps d'épreuve d'un appareil de pesage.

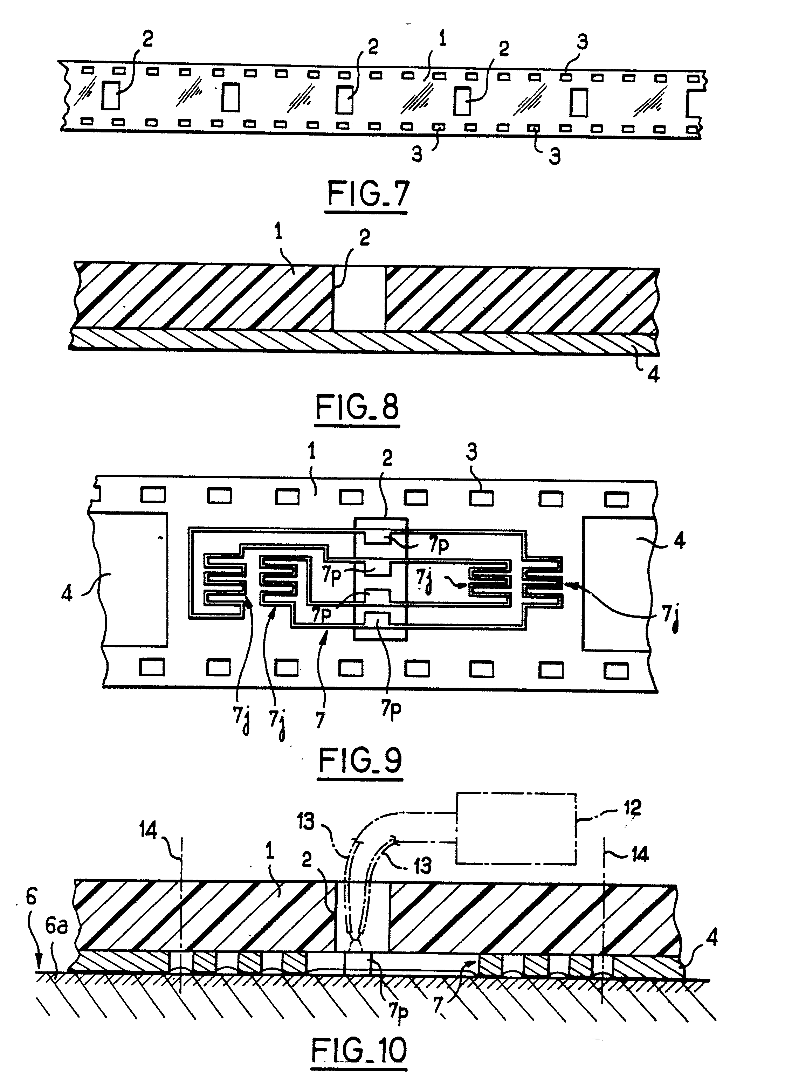

Dans l'exemple représenté aux figures 7 à 10, le film-support 1 comprend les mêmes ouvertures d'entraînement 3 que dans l'exemple précédent, et des ouvertures 2 plus courtes, relativement à la direction longitudinale du film, que les ouvertures 2 de la figure 1.

Comme le montre la figure 8, la couche métallique 4 est collée directement contre l'une des faces du film 1. Par "collée directement", on veut dire que la colle interposée entre le film 1 et la couche 4 n'a pas d'épaisseur sensible et, plus précisément, n'a pas une épaisseur qui serait suffisante pour soutenir le circuit 7 en regard d'une ouverture 2 de l'exemple des figures 1 à 6. D'ailleurs, dans le présent exemple, la colle est appliquée sur le film 1 de sorte qu'elle n'est pas présente dans les ouvertures 2.

Ensuite, comme le montre la figure 9, on grave la couche 4 par photogravure pour réaliser un circuit électrique passant par des résistances sensibles 7j et présentant des surfaces de connexion 7p. Il est fait en sorte que toutes les surfaces de connexion 7p soient en regard de l'ouverture 2. Par ailleurs, la quasi-totalité du circuit 7 est portée par le film-support 1 de part et d'autre de l'ouverture 2. Notamment, les quatre résistances 7j sont entièrement situées en dehors de l'ouverture 2.

D'autre part, on fait subir à une partie au moins de la surface du corps d'épreuve métallique 6 - (figure 4) un traitement chimique de surface permettant de développer en surface une couche 6a d'oxydes isolants (phosphatation, anodisation,....).

Ensuite (figure 10), on amène vers le corps d'épreuve 6 la jauge de contrainte ainsi réalisée de façon que la couche métallique 4 soit adjacente au corps d'épreuve.

Préalablement, une couche de colle a été déposée sur la surface isolante 6a du corps d'épreuve 6, qui est inchangé par rapport à l'exemple précédent. On appuie sur le film-support 1 pour appliquer le circuit 7 sur l'emplacement encollé de la surface 6a du corps 6. On fait en sorte qu'il ne reste qu'une épaisseur insignifiante de colle entre le circuit 7 et le corps 6, la colle semi-liquide étant chassée entre les différentes branches ou contours du circuit 7 comme cela est représenté en trait fin à la figure 10. l'adhérance et le couplage mécanique des résistances 7j avec le corps d'épreuve sont favorisés par cet enrobage.

Après cela, comme représenté - schématiquement et en trait mixte à la figure 10, on relie électriquement les surfaces 7p avec un équipement d'exploitation 12 en faisant passer des conducteurs 13 à travers l'ouverture 2 du film-support.

Avant ou après cette dernière opération, on coupe le film-support 1 selon les deux traits mixtes 14 représentés à la figure 10 de part et d'autre de l'ouverture 2, de façon à ne laisser subsister sur le corps d'épreuve que le circuit 7 et la région du film 1 qui est directement adjacente à ce dernier. On éloigne du corps 6 le reste du film 1.

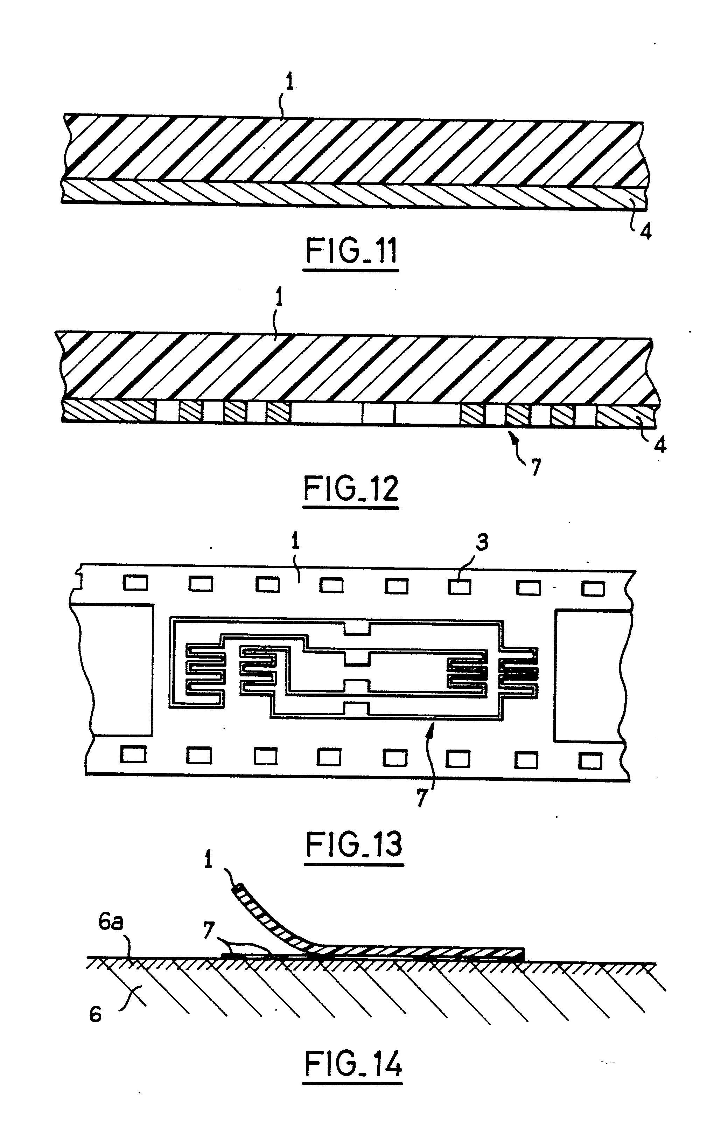

Dans l'exemple représenté aux figures 11 à 14, on part d'un film-support 1 n'ayant que des ouvertures 3, et non plus les ouvertures 2. Le film est muni d'une couche métallique 4 comme cela était décrit dans l'exemple précédent, et on grave des régions de la couche métallique 4 qui se succèdent le long du film-support 1 de façon à former des circuits électriques 7 successifs le long du film 1.

Un tel circuit 7 est représenté aux figures 12 et 13. Dans l'exemple représenté, le circuit 7 est analogue à celui des exemples précédents.

Pour le collage de chaque jauge de contrainte sur le corps d'épreuve 6, on procède comme décrit à propos de l'exemple précédent. Une fois le collage effectué, on découpe le film-support de part et d'autre du circuit 7 comme cela a été également décrit.

La colle qui a été utilisée pour assembler le film-support 1 et la couche 4 est une colle à faible adhérance. Lorsque la jauge a été placée sur le corps 6 comme il a été dit précédemment, et que la prise de la colle reliant le circuit 7 au corps 6 a eu lieu, on détache le film-support 1 du circuit 7 par une action de pelage comme cela est représenté à la figure 14. Ainsi, il ne reste plus en service sur le corps 6 que le circuit 7 et la colle pour l'associer au corps 6. Ceci facilite les opérations de raccordement électrique du circuit 7 et le cas échéant d'ajustage des valeurs électriques du circuit 7. De plus, comme d'ailleurs dans le premier exemple décrit, le film-support 1 ne peut plus en aucune manière influer sur la transmission des déformations, par exemple ne peut plus avoir d'influence tendant à maintenir le circuit 7 dans sa forme initiale lorsque le corps d'épreuve 6 subit une déformation.

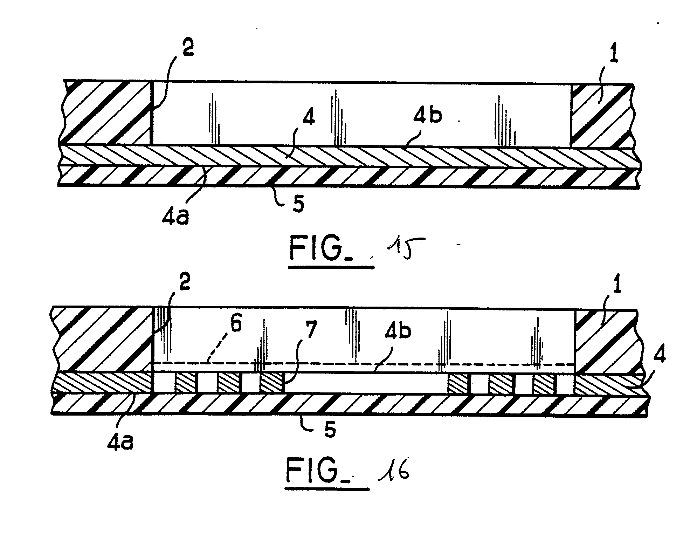

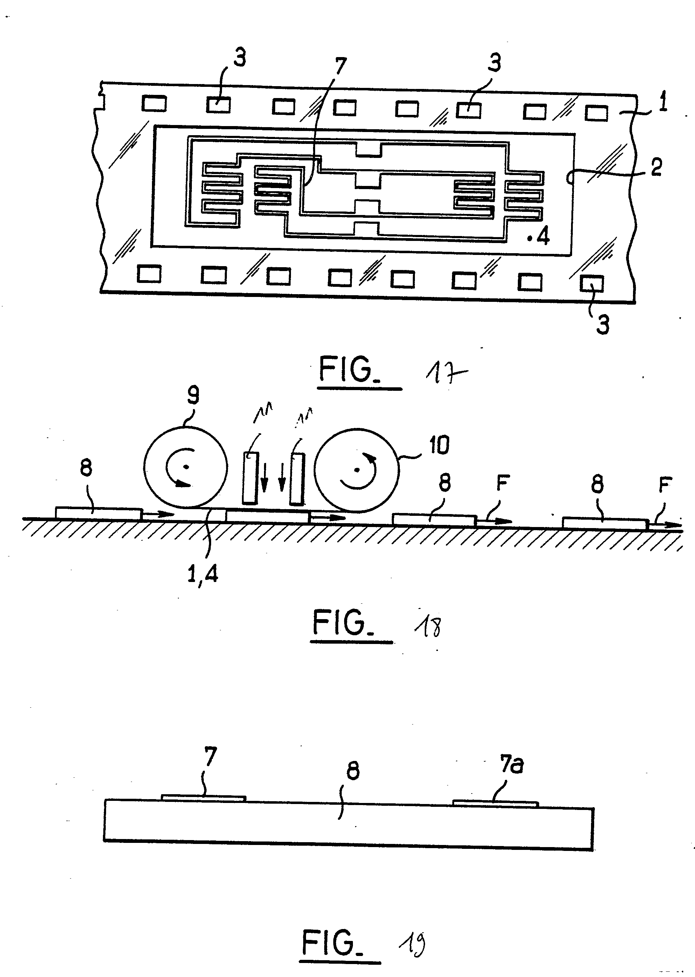

En référence aux figures 15 à 17, le procédé pour la fabrication de jauges de contraintes comprend les étapes suivantes :

-on réalise comme décrit précédemment (voir figure 1) dans une bande de support 1 en matière plastique, des ouvertures 2 régulièrement espacées, en même temps que des ouvertures latérales 3 de plus faibles dimensions, destinées à l'entraînement de la bande 1 ;

-on colle (voir figures 2 et 15) sur cette bande de support 1 en matière plastique, une bande métallique 4 ;

-on dépose (voir figure 15) sur la face 4a de cette bande métallique 4, opposée à la bande de support 1, une couche de matière adhésive 5 réticulable ;

-on dépose sur la face 4b de la bande métallique 4 adjacente aux ouvertures 2 ménagées dans la bande de support 1 en matière plastique, une couche 6 de matière photosensible (représentée en pointillés sur la figure 16);

-on forme sur cette couche 6 de matière photosensible par insolation et photogravure selon une méthode classique, une image reproduisant les contours du circuit électrique à graver et ;

-on grave un circuit électrique 7 (voir figure 16) sur la bande métallique 4 à travers le masque, par attaque chimique ou électrolytique classique.

--- --

Les figures 18 et 19 illustrent la fabrication d'un capteur de force 8 pour appareil de pesage comportant sur l'une de ses faces, des jauges de contraintes comprenant des circuits électriques 7, 7a réalisés selon le procédé que l'on vient de décrire.

Les circuits électriques 7, 7a sont gravés sur une bande 4 en alliage résistif, à travers le masque formé dans les ouvertures 2 de la bande de support 1 en matière plastique.

Dans une étape suivante, la face de la bande 4 en alliage résistif revêtue par la couche de matière adhésive 5 est collée sur une face du corps d'épreuve 8 de l'appareil de pesage.

L'alliage résistif de la bande 4 peut être par exemple du nickel-chrome ou du constantan.

L'épaisseur de la bande 4 d'alliage résistif peut être comprise entre 2 et 10 $\mu$m.

La bande de support 1 en matière plastique peut être en polyester, en polyimide ou en résine époxy chargée de fibres de verre.

L'épaisseur de cette bande de support 1 en matière plastique peut être comprise entre 20 et 100 $\mu$m.

La couche adhésive 5 peut être par exemple en résine époxy ou polyimide ou résine thermofusible.

Après avoir réalisé les circuits électriques tels que 7 et 7a, on découpe l'ensemble constitué par la bande de support 1 en matière plastique et la bande 4 en alliage résistif tout autour des ouvertures 2 réalisées dans la bande de support 1, de façon à séparer les uns des autres les circuits électriques 7, 7a, gravés dans la bande en alliage résistif, après quoi les éléments ainsi découpés comportant les circuits électriques gravés, sont collés sur le corps d'épreuve 8 (voir figure 19).

Ces opérations de découpage et de collage peuvent être réalisées en continu comme montré par le schéma de la figure 18. Comme indiqué sur ce schéma, on déplace en continu, suivant une direction rectiligne F, une série de corps d'épreuve 8 régulièrement espacés et on déplace en continu au-dessus de ces corps d'épreuve 8 la bande de support 1 en matière plastique portant les circuits électriques 7, 7a gravés dans la bande 4 en alliage résistif, cet ensemble étant déroulé d'une bobine 9 et enroulé sur une bobine 10.

On découpe en continu la bande support 1 et la bande en alliage résistif 4 au-dessus de chaque corps d'épreuve 8, de façon à séparer les circuits électriques 7, 7a les uns des autres et en même temps on colle ces circuits 7, 7a sur les corps d'épreuve 8 respectifs.

Les opérations de découpage et de collage peuvent être réalisées simultanément au moyen d'outils 11 exerçant successivement une pression sur la bande 1 qui a pour effet d'appliquer la bande 1 et la bande 4 sur le corps d'épreuve 8, de découper ces bandes autour des circuits 7, 7a et de coller la couche adhésive 5 contre le corps d'épreuve 8.

Ce collage peut être réalisé éventuellement par thermofusion de la couche adhésive 5.

Les principaux avantages et effets techniques du procédé que l'on vient de décrire sont les suivants :

La bande continue 1 en matière plastique permet une gravure simultanée d'un grand nombre de circuits électriques 7, 7a et de leur circuit d'interconnexion si nécessaire (figure 5).

Cette bande continue 1 facilite la manipulation des circtuis électriques, tout en les protégeant.

Cette bande continue 1 ainsi que la couche de matière adhésive 5 évitent que la bande méllique 4 soit attaquée chimiquement lors de la gravure, en d'autres endroits que dans les ouvertures 2.

La matière adhésive 5 sert de support aux circuits électriques 7, 7a après leurs gravure et permet de coller les jauges sur un support tel que le corps d'épreuve 8 d'un appareil de pesage, tout en isolant électriquement les circuits de ce support.

Par ailleurs, le procédé décrit en référence à la figure 18 permet de positionner avec précision et d'une manière parfaitement reproductible, les jauges de contraintes sur les corps d'épreuve 8, de sorte qu'on limite ainsi les rebuts et que l'on facilite les opérations d'étalonnage de ces capteurs de force.

L'invention n'est pas limitée aux exemples décrits.

Par exemple, le circuit électrique peut comporter des moyens d'ajustement de ses valeurs électriques.

Le corps d'épreuve peut être en matière isolante. En particulier, dans un appareil de pesage, on a le choix de la matière du corps d'épreuve, et celui-ci peut par exemple être en céramique ou en matière plastique composite renforcée.

Si le corps d'épreuve est conducteur, la couche isolante peut être constituée par une couche rapportée, par exemple une couche de résine (telle que colle époxy) que l'on fait polymériser avant d'y coller la jauge de contrainte. Une couche isolante peut encore être développée par bombardement d'alumine sous vide.

Dans l'exemple des figures 7 à 10, il pourrait y avoir plus d'une ouverture telle que 2 pour chaque circuit, par exemple une ouverture pour chaque surface telle que 7p.

Dans les exemples des figures 7 à 14, on pourrait rapporter une couche de matière adhésive sur la couche 4 déjà gravée, laisser polymériser cette couche puis la coller par sa face libre contre le corps d'épreuve n'ayant pas subi de traitement pour être rendu isolant en surface.

## Revendications

1. Procédé pour fabriquer une jauge de contrainte et l'appliquer sur un corps d'épreuve, caractérisé par les étapes suivantes :

-on colle une couche métallique (4) sur l'une des faces d'un film-support (1) ;

-on grave la couche métallique (4) selon les contours d'un circuit électrique (7) comprenant au moins une résistance sensible (7j) ;

-on amène l'ensemble film-support (1) -circuit (7) sur une surface isolante (6a) du corps d'épreuve -(6) de façon que le circuit (7) soit interposé entre le film-support (1) et le corps d'épreuve (6) ; et

-on colle le circuit électrique (7) sur la surface isolante (6a) du corps d'épreuve (6).

2. Procédé selon la revendication 1, caractérisé en ce qu'on fait subir au corps d'épreuve (6) un traitement de surface pour lui donner une surface isolante (6a) destinée à recevoir le circuit électrique (7) lors du collage de ce dernier.

3. Procédé selon l'une des revendications 1 ou 2, caractérisé en ce que, lors du collage sur le corps d'épreuve (6), de la matière adhésive à l'état semi-liquide est mise au contact du circuit électrique (7) de façon à pénéter entre les contours du circuit électrique (7) et à y demeurer après prise de la matière adhésive (5).

4. Procédé selon l'une des revendications 1 à 3, caractérisé en ce qu'on pèle le film-support (1) pour le détacher du circuit électrique après collage de celui-ci sur le corps d'épreuve.

5. Procédé selon l'une des revendications 1 à 3, caractérisé en ce qu'on pratique au moins une ouverture (2) dans le film-support (1), on grave la couche métallique (4) de façon que des surfaces de connexion (7p) et/ou d'ajustement de ce circuit -(7) soient en regard de l'ouverture (2) et, après collage du circuit (7) sur le corps d'épreuve (6), on raccorde électriquement le circuit électrique (7) avec un équipement d'exploitation (12) à travers l'ouverture (2) du film-support (1), le film-support -(1) subsistant en service sur le circuit électrique -(7) pour protéger électriquement et mécaniquement ce dernier.

6. Procédé pour fabriquer une jauge de contrainte et l'appliquer sur un corps d'épreuve, caractérisé par les étapes suivantes :

-on grave, selon les contours d'un circuit électrique (7) comprenant au moins un résistance sensible (7j), une couche métallique (4) portée par une film-support (1) ;

-après avoir polymérisé, au contact de la couche métallique (4), une couche de matière adhésive (5) de façon que celle-ci ait, dans la région du circuit -(7), une face libre (5a) et une face (5b) adjacente au circuit (7), on colle sur le corps d'épreuve (6) la face libre (5a) de la couche de matière adhésive polymérisée (5).

7. Procédé selon la revendication 6, caractérisé en ce qu'on pratique une ouverture (2) dans le film-support, on associe la couche métallique (4) au film-support (1) par interposition de la couche de matière adhésive (5), on grave la couche métallique (4) de façon que le circuit électrique (7) s'inscrive dans l'ouverture (2) lorsqu'il est vu transversalement au film-support (1), on amène l'ensemble film-support (1) -couche adhésive (5) -circuit électrique (7) sur le corps d'épreuve (6), le film-support (1) étant adjacent au corps d'épreuve -(6), et on pousse le circuit électrique (7) contre le corps d'épreuve (6) à travers l'ouverture (2) pour coller contre le corps d'épreuve (6) la matière adhésive (5) supportant le circuit électrique (7), puis on éloigne le film-support (1).

8. Procédé selon la revendication 6, caractérisé en ce que :

-avant de coller la couche métallique (4) sur le film-support (1), on réalise une ouverture (2) dans le film-support (1) ;

-après collage de la couche métallique (4) sur le film-support (1), on dépose la couche de matière adhésive (5) sur la face de cette couche métallique (4) opposée au film-support ;

-on dépose sur la face de la couche métallique (4) adjacente aux ouvertures (2) ménagées dans le film -support (1) en matière plastique, une couche 6 de matière photosensible ;

-on forme sur cette couche (6) de matière photosensible par insolation au travers d'un masque et photogravure, une image reproduisant les contours du circuit électrique à graver ; et

-on grave ledit circuit électrique (7) sur la couche métallique (4), par attaque chimique ou électrolytique.

9. Procédé conforme à l'une des revendications 1 à 8, caractérisé en ce qu'on utilise pour la couche métallique (4) un alliage résistif choisi dans le groupe comprenant le nickel-chrome et le constantan.

10. Procédé conforme à la revendication 9, caractérisé en ce que l'épaisseur de la couche (4) d'alliage résistif est comprise entre 2 et 10 $\mu$m.

11. Procédé conforme à l'une des revendications 1 à 10, caractérisé en ce qu'on utilise un film-support en une matière plastique choisie dans le groupe comprenant : polyester, polyimide et résine époxy chargée de fibres de verre.

12. Procédé conforme à la revendication 11, caractérisé en ce que l'épaisseur du film-support -(1) en matière plastique est comprise entre 20 et 100 $\mu$m.

13 Procédé selon l'une des revendications 1 à 12, caractérisé en ce que, dans le cadre d'une fabrication en série sur un film-support (1) en forme de bande portant sur l'une de ses faces une couche métallique (4) en forme de bande, on grave des régions de la bande métallique (4) qui se succèdent le long du film (1), de façon à former des circuits électriques (7) successifs le long du film (1).

14. Procédé conforme à la revendication 13, caractérisé en ce qu'on découpe l'ensemble constitué par le film-support (1) en matière plastique et la bande métallique (4), de part et d'autre d'ouvertures (2) que présente le film-support en regard des jauges de contrainte, de façon à séparer les unes des autres les jauges de contrainte (7, 7a), après quoi les éléments ainsi découpés comportant les circuits électriques gravés sont collés sur le corps d'épreuve (8).

15. Procédé conforme à la revendication 14, caractérisé en ce que les jauges de contrainte et leur interconnexion sont réalisées dans une même ouverture (2).

16. Procédé conforme à l'une des revendications 13 à 15, caractérisé en ce qu'on déplace en continu suivant une direction rectiligne (F) une série de corps d'épreuve (8) régulièrement espacés, on déplace en continu au-dessus de ces corps d'épreuve, le film-support (1) en matière plastique portant les circuits électriques (7, 7a) gravés dans la bande métallique (4), on découpe en continu le film-support (1) au-dessus de chaque corps d'épreuve (8) de façon à séparer les jauges de contrainte les unes des autres et en même temps on colle ces jauges de contrainte sur les corps d'épreuve (8).

17. Jauge de contrainte comprenent un film-support (1) et un circuit électrique (7) à au moins une résistance sentible (7j) associé au film-support (1) par collage, notamment comme produit intermédiaire obtenu au cours de la mise en oeuvre du procédé selon l'une des revendications 1 à 4, caractérisée en ce que le collage associant le circuit (7) au film-support (1) est d'un type à faible adhérance permettant de détacher le film-support (1) du circuit (7) par pelage.

18. Jauge de contrainte comprenant un film-support (1) et un circuit électrique (7) à au moins une résistance sensible (7j) associé au film support (1) par collage, notamment comme produit intermédiaire obtenu au cours de la mise en oeuvre du procédé selon la revendication 5, caractérisée en ce que le film-support (1) présente une ouverture (2) donnant accès, depuis le côté du film-support (1) opposé au circuit (7), à des surfaces de connexion (7p) du circuit électrique (7), le circuit électrique (7) étant collé au film-support (1) en dehors de l'ouverture précitée (2).

19. Jauge de contrainte comprenant un film-support (1) et un circuit électrique (7) associé au film-support (1) par collage, notamment comme produit intermédiaire obtenu au cours de la mise en oeuvre du procédé selon la revendication 7, caractérisé en ce qu'il comprend une couche intermédiaire (5) entre le film-support (1) et le circuit électrique (7), ce dernier étant porté par la couche intermédiaire (5) et s'inscrivant dans une ouverture (2) du film-support (1) lorsqu'il est vu perpendiculairement au film-support (1).

20. Jauge de contrainte selon l'une des revendications 17 à 19, caractérisée en ce qu'elle fait partie d'une bande formée de jauges de contrainte successives semblables.

## FIG.1

## FIG.2

## FIG.3

FIG.5

FIG.4

FIG.6

FIG. 7

FIG. 8

FIG. 9

FIG. 10

FIG.11

FIG.12

FIG.13

FIG.14

FIG. 15

FIG. 16

FIG. 17

FIG. 18

FIG. 19

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| .A | FR-A-1 392 270  (N.V. PHILIPS' GLOEILAMPENFABRIEKEN)<br>* En entier * | 1,6 | G 01 L   1/22 |
| A | US-A-2 457 616  (W.D. VAN DYKE et al.)<br>* En entier * | 1,6 | |
| A | US-A-3 374 454  (G. HOLLAND et al.)<br>* En entier * | 1,6 | |
| A | EP-A-0 160 419  (TOKYO ELECTRIC CO. LTD)<br>* Page 3,  ligne 13 - page 4, ligne 17; figures 2,3 * | 8,14, 15 | |
| A | US-A-3 990 926  (J. KONICEK)<br><br>* Revendications 1,5; figure 17 * | 8,10, 11 | |

DOMAINES TECHNIQUES
RECHERCHES (Int. Cl.4)

G 01 L     1
G 01 B     7
G 01 G     3
H 05 K     3

Le présent rapport de recherche a été établi pour toutes les revendications

| Lieu de la recherche | Date d'achèvement de la recherche | Examinateur |
|---|---|---|
| LA HAYE | 12-03-1987 | VAN ASSCHE P.O. |